# FASCICULE DE BREVET EUROPEEN

(11) **EP 2 032 301 B1**
(45) Date de publication et mention de la délivrance du brevet: **11.07.2012**
(21) Numéro de dépôt: 06778609.5
(22) Date de dépôt: 16.06.2006
(51) Int. Cl.: B23K 26/03, B23K 26/06, B23K 1/005, H01S 3/131, H01S 3/00

(54) **PROCEDE ET DISPOSITIF DE CONTROLE DE LA PUISSANCE TRANSMISE PAR UN FAISCEAU LASER EN UN POINT DE REFERENCE, DISPOSITIF ET PROCEDE DE BRASAGE**
VERFAHREN UND VORRICHTUNG ZUR STEUERUNG DER VON EINEM LASERSTRAHL ÜBERTRAGENEN ENERGIE IN EINEM BEZUGSPUNKT, HARTLÖTVERFAHREN UND -VORRICHTUNG
METHOD AND DEVICE FOR CONTROLLING THE POWER TRANSMITTED BY A LASER BEAM IN A REFERENCE POINT, BRAZING METHOD AND DEVICE

(43) Date de publication de la demande: 11.03.2009
(73) Titulaire: Valeo Etudes Electroniques, 94042 Créteil Cédex (FR)
(72) Inventeur: MORELLE, Jean-Michel, 45190 Beaugency (FR); VIVET, Laurent, 78390 Bois d'Arcy (FR)
(74) Mandataire: Cardon, Nicolas
(86) Numéro de dépôt international: PCT/FR2006/001374
(87) Numéro de publication internationale: WO 2007/144477

(56) Documents cités:
- DE-A1- 3 820 848
- GB-A- 1 250 847
- JP-A- 58 212 889
- US-A- 4 684 796
- US-A- 4 930 901
- US-A1- 2004 084 426
- US-B1- 6 831 936

## Description

La présente invention concerne un procédé et un dispositif de contrôle de la puissance transmise par un faisceau laser en un point de référence selon les préambules de la revendication 1 et de la revendication 8 respectivement. Un tel procédé et un tel dispositif sont connus de US 6 831 936 B. L'invention concerne aussi un dispositif et un procédé de brasage, notamment d'un organe sur un support.

Elle s'applique plus particulièrement au brasage d'une pastille semi-conductrice sur un support comportant une partie métallique, la partie métallique pouvant être bordée, au moins partiellement, par une partie en matériau synthétique destinée à isoler électriquement la partie métallique.

La brasure se présente, de façon classique, sous forme d'une pâte à braser ou d'un fin ruban découpé en disque ou en rectangle que l'on dépose entre l'organe à braser, par exemple une pastille semi-conductrice, et le support.

En général, la brasure est formée dans un matériau, par exemple un alliage de plomb et d'étain, dont la température de fusion est inférieure à la température de fusion de la pastille semi-conductrice et du support à braser.

Ainsi, lorsque l'on chauffe l'ensemble constitué de la pastille, de la brasure et du support à la température de fusion de la brasure, la brasure fond et permet, en refroidissant, l'assemblage de la pastille sur le support.

On connaît déjà dans l'état de la technique un dispositif de brasage d'un organe sur un support comportant des première et seconde faces opposées, l'organe à braser étant destiné à être porté par la première face du support, le dispositif de brasage étant du type comprenant une source de faisceau laser émettant un faisceau sur la seconde face du support, sensiblement au droit de l'organe à braser.

Un tel dispositif de brasage est décrit, par exemple, dans GB -A- 1 250 847. Ainsi, ce document propose d'appliquer un faisceau laser sur la seconde face du support. La chaleur produite par le faisceau laser se propage alors à travers l'épaisseur du support. Lorsque la brasure atteint sa température de fusion, la brasure fond et permet le brasage de l'organe sur la première face du support. Le support décrit dans le document est en céramique.

Or, on souhaite pouvoir braser au moyen d'un dispositif du type précité un organe tel qu'une pastille semi-conductrice sur un support bi-matière comprenant une partie métallique bordée d'une partie en matière synthétique (plastique) formant isolant électrique.

La partie en matière synthétique a, généralement, une température de fusion inférieure à celle de la brasure. Par conséquent, la chaleur se propageant également latéralement dans le support, la partie en matière synthétique risque d'être endommagée au cours du brasage de la pastille sur le support à moins de maîtriser efficacement la puissance transmise au support par le faisceau laser.

On connaît déjà dans l'état de la technique, notamment d'après GB -A-1 250 847, un procédé de contrôle de la puissance transmise par un faisceau laser en un point de référence, du type dans lequel on interrompt périodiquement la transmission du faisceau laser à l'aide de moyens de masquage du faisceau laser placés entre le point de référence et une source du faisceau laser.

Toutefois, le procédé de contrôle décrit dans GB -A-1 250 847 ne permet pas un contrôle suffisamment précis de la puissance transmise par le faisceau laser au point de référence.

En effet, dans GB -A-1 250 847, la puissance transmise au point de référence par le faisceau laser est contrôlée à l'aide de moyens de masquage, situés entre la source du faisceau laser et le point de référence, comprenant un disque dans lequel est découpé un secteur angulaire formant une fenêtre qui laisse passer périodiquement le faisceau laser lorsque le disque est en rotation.

Dans GB -A-1 250 847, les périodes d'interruption de la puissance transmise par le faisceau laser sont ajustées en réglant la vitesse de rotation angulaire du disque et/ou l'angle de la fenêtre du disque.

Toutefois, les moyens de masquage proposés par GB -A-1 250 847 ont pour inconvénient de couvrir et découvrir progressivement le faisceau laser pendant une période transitoire au cours de laquelle le masquage du faisceau laser est partiel.

Cette période transitoire peut être relativement longue, et est variable car soumise aux aléas d'usure mécanique des éléments constituant les moyens de masquage.

De ce fait, il est difficile de contrôler la puissance transmise au point de référence par le faisceau laser car, au cours des périodes transitoires, la puissance transmise varie progressivement d'une valeur maximale à une valeur nulle, cette excursion en puissance pouvant être relativement grande.

L'invention a pour but d'optimiser le contrôle de la puissance transmise par le faisceau laser en un point de référence situé par exemple sur un support bi-matière métal-plastique, notamment afin de limiter la propagation latérale de la chaleur dans le support bi-matière et ainsi de protéger la partie en matière synthétique du support des fortes températures.

A cet effet, l'invention a pour objet un procédé de contrôle selon la revendication 1.

Comme la durée de masquage coïncide sensiblement avec la durée d'émission de la source du faisceau laser à la puissance minimale, la période transitoire au cours de laquelle le faisceau laser est partiellement masqué, correspond à une durée au cours de laquelle le faisceau laser a une puissance minimale.

Ainsi, on réduit l'excursion en puissance au cours de la période transitoire, ce qui permet de contrôler précisément la puissance transmise au point de référence et de limiter la propagation latérale de la chaleur dans le support.

De préférence, la valeur maximale est au plus égale à 90% de la puissance maximale d'émission de la source du faisceau laser. Dans ce cas, la puissance transmise par le faisceau laser au point de référence varie également entre une valeur minimale au moins égale à 10% et une valeur maximale au plus égale à 90% d'une puissance de transmission maximale de la source du faisceau laser.

Ainsi, en considérant que l'on fait varier la puissance d'émission entre des valeurs minimale et maximale correspondant respectivement à 10% et 90% de la puissance d'émission maximale de la source laser, au cours de la période durant laquelle le faisceau est partiellement masqué, la puissance transmise au point de référence ne peut excéder 10% de la puissance transmise maximale par le faisceau laser au point de référence.

En particulier, la source laser peut être une diode laser, par exemple du type à infrarouge. Dans ce cas, afin de préserver la durée de vie de la diode laser, on fait varier la puissance d'émission de la diode entre une valeur minimale de 10% et une valeur maximale de 70% de la puissance d'émission maximale de la diode laser.

Le procédé de contrôle de la puissance transmise selon l'invention peut en outre comporter les caractéristiques optionnelles suivantes :
- on pilote les variations de la puissance transmise au point de référence par le faisceau laser et les moyens de masquage du faisceau lumineux avec des moyens informatiques de pilotage ;
- on asservit les moyens de pilotage à l'aide de moyens de mesure de la température d'un organe en contact thermique avec le point de référence ;
- le faisceau laser est focalisé sur le point de référence.

L'invention a encore pour objet un dispositif de contrôle de la puissance transmise par un faisceau laser en un point de référence selon la revendication 8.

Le dispositif de contrôle de la puissance transmise selon l'invention peut en outre comporter les caractéristiques optionnelles suivantes :
- la source laser comporte une diode laser, par exemple du type à infrarouge;
- le dispositif comprend des moyens informatiques de pilotage des moyens de commande de la puissance transmise par le faisceau laser au point de référence et des moyens de masquage du faisceau laser ;
- les moyens de pilotage sont asservis à la température d'au moins une zone dont la température est influencée par celle du point de référence, à l'aide de moyens de mesure de cette température reliés aux moyens de pilotage ;
- les moyens de température comportent un pyromètre infrarouge comprenant des moyens de formation d'une image infrarouge de la zone.

L'invention a encore pour objet un dispositif de brasage d'un organe sur un support comportant des première et seconde faces opposées, l'organe à braser étant destiné à être porté par la première face du support, le dispositif de brasage étant du type comprenant une source de faisceau laser émettant un faisceau sur la seconde face du support, sensiblement au droit de l'organe à souder, caractérisé en ce qu'il comprend le dispositif de contrôle tel que défini ci-dessus pour le contrôle de la puissance transmise sur le faisceau laser en un point de référence formant un point de focalisation du faisceau laser sur la seconde face.

Le dispositif de brasage selon l'invention peut en outre comporter les caractéristiques optionnelles suivantes :
- le dispositif comprend des moyens de guidage, comportant une fibre optique et des moyens amont de focalisation du faisceau dans une extrémité amont de la fibre optique, destinés à guider le faisceau laser depuis les moyens de masquage jusqu'au point de référence ;
- le dispositif comprend des moyens aval de focalisation sur le point de référence du faisceau laser émis par une extrémité aval de la fibre optique.

L'invention a encore pour objet un procédé de brasage d'un organe sur un support comportant une partie métallique bordée au moins partiellement par une partie en matériau synthétique, la partie métallique comportant des première et seconde faces opposées, l'organe à braser étant destiné à être porté par la première face de la partie métallique, caractérisé en ce que l'on brase l'organe sur la partie métallique du support au moyen du dispositif de brasage tel que défini ci-dessus, le faisceau laser étant focalisé sur la seconde face de la partie métallique.

Le procédé de brasage selon l'invention peut en outre comporter les caractéristiques optionnelles suivantes :
- l'organe est une pastille semi-conductrice ;
- la partie métallique du support est destinée à être en contact électrique avec une borne d'organe électrique, notamment d'une borne d'alternateur d'un véhicule automobile, la partie en matériau synthétique isolant électriquement la partie métallique ;
- le dispositif de brasage comprenant un dispositif de contrôle tel que défini plus haut, les moyens de pilotage sont asservis à la température d'une première zone dont la température est influencée par celle du point de référence, cette première zone étant délimitée sur une partie de la surface de l'organe à braser ;
- les moyens de pilotage sont asservis à la température d'une seconde zone dont la température est influencée par celle du point de référence, cette seconde zone étant délimitée sur une partie de la surface du support, en particulier sur la partie métallique proche de la partie en matériau synthétique.

L'invention sera mieux comprise à la lecture de la description qui va suivre, donnée uniquement à titre d'exemple et faite en se référant aux dessins dans lesquels :
- la figure 1 est une vue schématique d'un dispositif de brasage d'un organe sur un support selon l'invention ;
- la figure 2 est un graphique représentant une courbe d'évolution de l'état de moyens de masquage du faisceau laser en fonction du temps ;
- la figure 3 est un graphique représentant une courbe d'évolution de la puissance émise par une source de faisceau laser en fonction du temps ;
- la figure 4 est un graphique représentant une courbe d'évolution de la puissance transmise à un point de référence par le faisceau laser en fonction en fonction du temps.

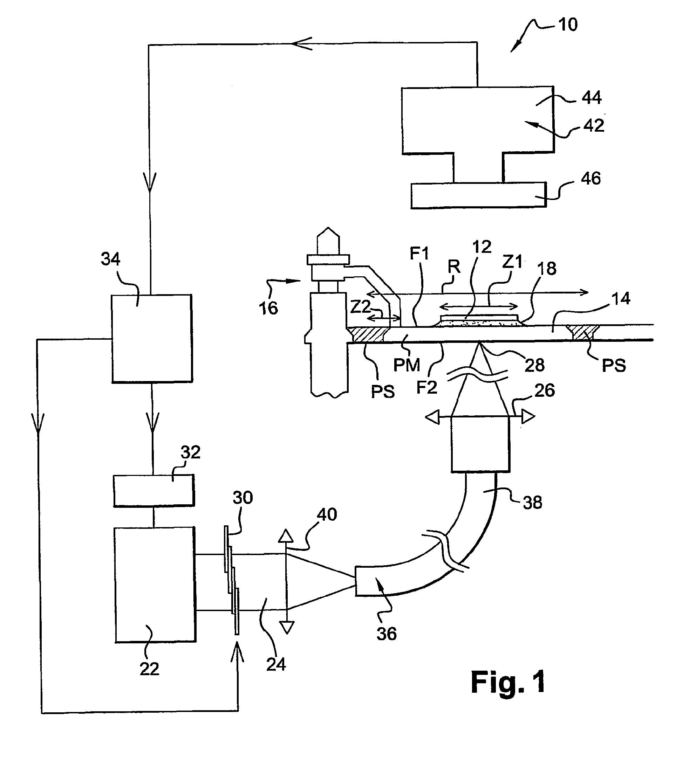

On a représenté sur la figure 1, un dispositif de brasage selon l'invention, désigné par la référence générale 10.

Le dispositif 10 permet de braser un organe 12 sur un support 14 destiné à être raccordé à une borne électrique 16 d'un alternateur (non représenté) de véhicule automobile.

Dans l'exemple décrit, l'organe 12 est une pastille semi-conductrice, de type classique.

De plus, dans l'exemple décrit, le support 14 comporte une partie métallique PM, notamment en cuivre, bordée au moins partiellement par une partie PS en matériau synthétique (plastique).

La partie métallique PM comporte des première F1 et seconde F2 faces opposées, l'organe 12 étant destiné à être porté par la première face F1. De préférence, la face F1 est recouverte d'une fine couche de nickel.

La partie métallique PM assure de bonnes conductions électrique et thermique. Elle est raccordée électriquement à la borne 16. La partie synthétique PS forme un isolant électrique de la partie métallique PM.

Un matériau formant brasure 18 est intercalé entre la pastille semi-conductrice 12 et le support 14. De façon classique, la brasure 18 se présente sous forme de pâte à braser ou d'un fin ruban découpé en disque ou en rectangle.

La chaleur permettant de faire fondre la brasure 18 est fournie par l'énergie d'une source laser 22 émettant un faisceau 24.

La source laser 22 peut comporter, par exemple, une diode laser émettant un faisceau laser, par exemple du type à infrarouge.

Le faisceau laser 24 est focalisé par des moyens aval 26 de focalisation en un point de référence 28 situé sur la seconde face F2 de la partie métallique PM du support 14, au droit de l'organe 12.

Afin de contrôler la puissance transmise par le faisceau laser 24, le dispositif 10 comporte, d'une part, des moyens 30 de masquage du faisceau laser 24 destinés à interrompre périodiquement la transmission du faisceau laser 24 et, d'autre part, des moyens 32 de commande de la puissance d'émission de la source laser 22.

Les moyens de masquage 30 comprennent par exemple un diaphragme de type classique.

Les moyens de masquage 30 sont dits "ouverts", lorsque le faisceau laser 24 n'est pas masqué de façon que toute la puissance du faisceau soit transmise et "fermés", dans le cas contraire.

Les moyens 32 de commande et les moyens 30 de masquage sont pilotés par des moyens informatiques 34, par exemple, par un ordinateur.

Dans le but de réduire l'encombrement au voisinage du support 14, la source laser 22 est éloignée de ce support 14. Des moyens 36 guident le faisceau laser 24, depuis la source 22 jusqu'au point de référence 28.

Dans l'exemple illustré, les moyens 36 comportent une fibre optique 38 et des moyens amont 40 de focalisation du faisceau laser 24 dans la fibre optique 38.

La longueur totale de la fibre optique 38 peut, le cas échéant, atteindre 50 mètres, ce qui permet un éloignement relativement important par rapport au support 14 des éléments encombrants tels que la source 22 et le diaphragme 30.

Afin d'optimiser le contrôle de la puissance transmise par le faisceau laser 24, les moyens 34 de pilotage sont asservis à la température d'au moins une zone dont la température est influencée par celle du point de référence 28, à l'aide de moyens 42 de mesure de cette température reliés aux moyens de pilotage 34.

Dans l'exemple illustré, les moyens de pilotage 34 sont asservis à la température de première Z1 et seconde Z2 zones dont la température est influencée par celle du point de référence 28.

La première zone Z1 est délimitée sur une partie de la surface de l'organe 12, par exemple sur une surface de cet organe 12 opposée à celle en contact avec la brasure 18. L'organe 12 est en contact thermique avec le point de référence 28 par l'intermédiaire de la brasure 18 et de la partie métallique PM du support.

La seconde zone Z2 est délimitée sur une partie de la surface du support 14, en particulier sur la face F1 de la partie métallique PM, à proximité de la partie en matériau synthétique PS.

Les moyens de mesure 42 de la température peuvent comporter un pyromètre infrarouge 44 comprenant une caméra classique et des moyens 46 de formation d'une image infrarouge d'une région R englobant les zones Z1 et Z2.

Les moyens 46 peuvent, par exemple, comporter un objectif avec un grand angle de champ adapté à la dimension de la région R et avec un grandissement suffisant pour obtenir une bonne résolution des zones ou éléments pertinents, par exemple de la pastille semi-conductrice 12.

Conformément au procédé de brasage de l'invention, on focalise le faisceau laser 24 sur le point de référence 28 et on contrôle la puissance transmise par le faisceau laser 24 à ce point de référence 28, d'une part, en interrompant périodiquement, à l'aide des moyens de masquage 30, la transmission du faisceau laser 24 et, d'autre part, en faisant varier la puissance d'émission de la source 22 du faisceau laser 24 entre des valeurs minimale et maximale, de façon que des durées d'émission de la source 22 du faisceau laser 24 à la puissance minimale coïncident sensiblement avec des durées de masquage du faisceau laser 24 par les moyens de masquage 30.

Le terme « périodiquement » doit être compris dans le cadre de l'invention comme signifiant « de façon plus ou moins régulière ».

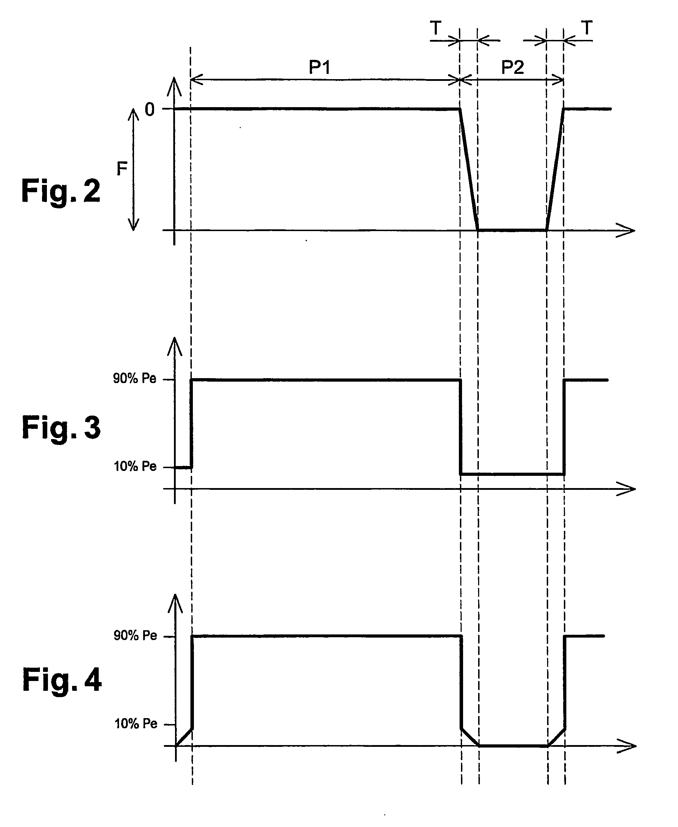

En considérant la courbe d'évolution de l'état des moyens de masquage 30 du faisceau laser 24 en fonction du temps représentée sur la figure 2, on voit une période P1 durant laquelle les moyens de masquage 30 sont dans l'état ouvert « O » et une période P2 durant laquelle les moyens de masquage 30 sont dans l'état fermé « F ».

On notera que la période P2 comprend des sous-périodes transitoires T au cours desquelles les moyens 30 masquent partiellement le faisceau laser 24.

De préférence, P1 est compris entre 500 et 1000 ms et P2 est compris entre 200 et 500 ms. En général, dans ce cas, T est compris entre 50 et 100 ms.

En considérant la courbe d'évolution de la puissance émise par la source laser 22 représentée sur la figure 3, on voit que les durées d'émission de la source 22 du faisceau laser 24 à la puissance minimale coïncident sensiblement avec la période P2 de masquage du faisceau laser 24. On voit également que, de préférence, on fait varier la puissance d'émission de la source 22 du faisceau laser 24 entre la valeur minimale de 10% et la valeur maximale de 90% d'une puissance maximale d'émission Pe de la source 22 du faisceau laser 24.

En variante, d'autres valeurs minimales et maximales sont possibles. On veillera de préférence à ce que la valeur minimale soit au moins égale à 10% et la valeur maximale au plus égale à 90% de la puissance maximale d'émission Pe de la source 22 du faisceau laser 24.

Par ailleurs, en considérant la courbe d'évolution de la puissance transmise par le faisceau laser 24 au point de référence 28 représentée sur la figure 4, on voit que la puissance transmise par le faisceau laser 24 au point de référence 28 est :
- égale à 90% d'une puissance de transmission maximale Pt du faisceau laser 24 au cours de la période P1, et
- nulle au cours de la période P2 exceptées au cours des sous-périodes T (en effet, au cours des sous-périodes T, la puissance transmise varie entre une valeur de 10% de la puissance de transmission maximale Pt et une valeur nulle).

En variante, dans le cas où la source 22 est une diode laser, par exemple du type à infrarouge, on peut faire varier la puissance d'émission de la diode laser émettant le faisceau laser 24 entre la valeur minimale de 10% et la valeur maximale de 70% de la puissance maximale d'émission Pe de la diode laser, afin de préserver la durée de vie de la diode laser. La puissance transmise par le faisceau laser (24) au point de référence 28 est alors égale à 70% de la puissance de transmission maximale Pt du faisceau laser 24 au cours de la période P1.

Ainsi, du fait que la puissance d'émission de la source 22 du faisceau laser 24 varie entre des valeurs minimale et maximale de façon à ce que les durées d'émission de la source 22 du faisceau laser 24 à la puissance minimale coïncident sensiblement avec des durées de masquage du faisceau laser 24 par les moyens de masquage 30, on optimise le contrôle de la puissance transmise, en particulier au cours des sous-périodes transitoires T dont les durées peuvent dépendre notamment de l'usure des moyens de masquage 30.

Les impulsions de puissance transmise conformes à la figure 4 permettent de contrôler efficacement la puissance du faisceau laser 24 transmise au point de référence 28. Le cas échéant, les moyens de masquage 30 peuvent être maintenus fermés et la puissance émise par la source 22 maintenue à une valeur de 10% de Pe, pour changer en toute sécurité la position du point de focalisation du faisceau laser 24 afin de braser un autre organe.

On décrira ci-dessous plus en détail le procédé de brasage selon l'invention mis en oeuvre par le dispositif 10.

Initialement, on considère les moyens de masquage 30 ouverts. Cet état correspond à la période P1 des courbes des figures 2, 3, et 4. La puissance émise par la source 22 du faisceau laser 24 correspond, dans ce cas, à une valeur maximale de 90% de la puissance maximale d'émission Pe de la source 22 du faisceau laser 24.

La puissance transmise par le faisceau laser 24 au point de référence 28 est alors égale à 90% de la puissance de transmission maximale Pt.

La chaleur fournie par l'énergie de la source laser 22 au point de référence 28 se propage dans le support 14 notamment :
- de la face F2 vers la face F1 de la partie métallique PM jusqu'à atteindre la brasure 18, la pastille semi-conductrice 12 et la zone Z1 délimitée sur cette pastille 12, et
- sensiblement parallèlement aux faces F1 et F2 jusqu'à atteindre la zone Z2 de la face F1 proche de la partie en matériau synthétique PS.

Ainsi, les températures des zones Z1 et Z2 augmentent.

Les moyens de pilotage 34 sont asservis aux températures des zones Z1 et Z2, mesurées par les moyens 42, de façon à modifier le rapport entre P1 et P2 en fonction de ces températures. Par exemple, lorsque la température de la zone Z1 atteint la température de fusion de la brasure 18 ou lorsque la température de la zone Z2 atteint une température critique risquant d'endommager la partie en matériau synthétique PS, les moyens 34 pilotent les moyens 30 et les moyens 32 de manière à ce que P1 diminue et P2 augmente ce qui a pour effet d'abaisser la puissance reçue par le point de référence 28.

Bien entendu, en variante, les moyens de pilotage 34 pourraient être asservis à la température d'une seule zone pertinente ou aux températures de plus de deux zones pertinentes.

On notera que, pendant une sous-période transitoire T, comme la puissance émise par la source 22 est minimale au cours de cette sous-période transitoire T, la puissance transmise au point de référence 28 est toujours inférieure ou égale à 10% de la puissance de transmission maximale Pt du faisceau laser 24 au point de référence 28.

Le procédé de brasage selon l'invention permet ainsi d'optimiser le contrôle de la puissance transmise par le faisceau laser 24.

## Revendications

1. Procédé de contrôle de la puissance transmise par un faisceau laser (24) en un point de référence (28), du type dans lequel on interrompt périodiquement la transmission du faisceau laser (24) à l'aide de moyens de masquage (30) du faisceau laser (24) placés entre le point de référence (28) et une source (22) du faisceau laser (24), **caractérisé en ce que** l'on fait varier la puissance d'émission de la source (22) du faisceau laser (24) entre des valeurs minimale et maximale, de façon que les durées d'émission de la source (22) du faisceau laser (24) à la puissance minimale coïncident sensiblement avec des durées de masquage du faisceau laser (24) par les moyens de masquage (30), les périodes de masquage du faisceau laser incluant des sous-périodes transitoires au cours desquelles le faisceau laser est partiellement masqué, le procédé étant en outre **caractérisé en ce que** la valeur minimale est au moins égale à 10% d'une puissance maximale d'émission de la source (22) du faisceau laser (24).

2. Procédé de contrôle selon la revendication 1, dans lequel la valeur maximale est au plus égale à 90% de la puissance maximale d'émission de la source (22) du faisceau laser (24).

3. Procédé de contrôle selon la revendication 2, dans lequel la source (22) du faisceau laser (24) est une diode laser, par exemple du type à infrarouge, et on fait varier la puissance d'émission entre la valeur minimale de 10% et la valeur maximale de 70% d'une puissance d'émission maximale de la diode laser.

4. Procédé de contrôle selon l'une des revendications 1 à 3, dans lequel la période (P1) durant laquelle le faisceau laser n'est pas masqué par les moyens de masquage est d'une durée comprise entre 500 et 1000 ms.

5. Procédé de contrôle selon l'une quelconque des revendications 1 à 4, dans lequel on pilote les variations de la puissance transmise au point de référence (28) par le faisceau laser (24) et les moyens de masquage (30) du faisceau laser (24) avec des moyens informatiques de pilotage (34).

6. Procédé de contrôle selon la revendication 5, dans lequel on asservit les moyens de pilotage (34) à l'aide de moyens de mesure (42) de la température d'au moins une zone (Z1, Z2) dont la température est influencée par celle du point de référence (28).

7. Procédé de contrôle selon l'une quelconque des revendications 1 à 6, dans lequel le faisceau laser (24) est focalisé sur le point de référence (28).

8. Dispositif de contrôle de la puissance transmise par un faisceau laser (24) en un point de référence (28), du type comprenant une source laser (22) émettant le faisceau laser (24), des moyens de masquage (30) du faisceau laser (24) destinés à interrompre périodiquement le faisceau laser (24) pendant des durées de masquage, **caractérisé en ce qu'**il comprend des moyens de commande (32) de la puissance d'émission de la source (22) du faisceau laser (24) entre des valeurs minimale et maximale de façon que des durées d'émission de la source (22) du faisceau laser (24) à la puissance minimale coïncident sensiblement avec des durées de masquage du faisceau laser (24) par les moyens de masquage (30), les périodes de masquage du faisceau laser incluant des sous-périodes transitoires au cours desquelles le faisceau laser est partiellement masqué, le dispositif étant en outre **caractérisé en ce que** la valeur minimale étant au moins égale à 10% d'une puissance maximale d'émission de la source (22) du faisceau laser (24).

9. Dispositif de contrôle selon la revendication 8, dans lequel la période (P1) durant laquelle le faisceau laser n'est pas masqué par les moyens de masquage est d'une durée comprise entre 500 et 1000 ms.

10. Dispositif de contrôle selon la revendication 8 ou 9, dans lequel la source laser (22) comporte une diode laser, par exemple du type à infrarouge.

11. Dispositif de contrôle selon l'une des revendications 8 à 10, comprenant des moyens informatiques de pilotage (34) des moyens de commande (32) de la puissance du faisceau laser transmise par la source et des moyens de masquage (30) du faisceau laser (24).

12. Dispositif de contrôle selon l'une quelconque des revendications 8 à 11, dans lequel les moyens de pilotage (34) sont asservis à la température d'au moins une zone (Z1, Z2) dont la température est influencée par celle du point de référence (28), à l'aide de moyens de mesure (42) de cette température reliés aux moyens de pilotage (34).

13. Dispositif de contrôle selon la revendication 12, dans lequel les moyens de mesure (42) de la température comportent un pyromètre infrarouge (44) comprenant des moyens de formation (46) d'une image infrarouge de la zone (Z1, Z2, R).

14. Dispositif de brasage d'un organe (12) sur un support (14) comportant des première (F1) et seconde (F2) faces opposées, l'organe (12) à braser étant destiné à être porté par la première face (F1) du support (14), le dispositif de brasage étant du type comprenant une source (22) de faisceau laser émettant un faisceau (24) sur la seconde face (F2) du support (14), sensiblement au droit de l'organe (12) à souder, **caractérisé en ce qu'**il comprend un dispositif de contrôle selon l'une quelconque des revendications 8 à 13 pour le contrôle de la puissance transmise sur le faisceau laser (24) en un point de référence (28) formant un point de focalisation du faisceau laser (24) sur la seconde face (F2).

15. Dispositif de brasage selon la revendication 14, comprenant des moyens de guidage (36), comportant une fibre optique (38) et des moyens amont de focalisation (40) du faisceau (24) dans une extrémité amont de la fibre optique (38), destinés à guider le faisceau laser (24) depuis les moyens de masquage (30) jusqu'au point de référence (28).

16. Dispositif de brasage selon la revendication 15, comprenant des moyens aval de focalisation (26) sur le point de référence (28) du faisceau laser (24) émis par une extrémité aval de la fibre optique (38).

17. Procédé de brasage d'un organe (12) sur un support (14) comportant une partie métallique (PM) bordée au moins partiellement par une partie en matériau synthétique (PS), la partie métallique (PM) comportant des première (F1) et seconde (F2) faces opposées, l'organe (12) à braser étant destiné à être porté par la première face (F1) de la partie métallique (PM), **caractérisé en ce que** l'on brase l'organe (12) sur la partie métallique (PM) du support (14) au moyen d'un dispositif de brasage selon l'une quelconque des revendications 14 à 16, le faisceau laser (24) étant focalisé sur la seconde face (F2) de la partie métallique (PM).

18. Procédé de brasage selon la revendication 17, dans lequel l'organe (12) est une pastille semi-conductrice.

19. Procédé de brasage selon la revendication 17 ou 18, dans lequel la partie métallique (PM) du support (14) est destinée à être en contact électrique avec une borne (16) d'organe électrique, notamment une borne d'alternateur de véhicule automobile, la partie en matériau synthétique (PS) isolant électriquement la partie métallique (PM).

20. Procédé de brasage selon l'une quelconque des revendications 17 à 19, dans lequel, le dispositif de brasage comprenant un dispositif de contrôle selon la revendication 10 ou 11, les moyens de pilotage (34) sont asservis à la température d'une première zone (Z1) dont la température est influencée par celle du point de référence (28), cette première zone (Z1) étant délimitée sur une partie de la surface de l'organe (12) à braser.

21. Procédé de brasage selon la revendication 20, dans lequel les moyens de pilotage (34) sont asservis à la température d'une seconde zone (Z2) dont la température est influencée par celle du point de référence (28), cette seconde zone (Z2) étant délimitée sur une partie de la surface du support (14), en particulier sur la partie métallique (PM) proche de la partie en matériau synthétique (PS).

## Claims

1. Method for controlling the power transmitted by a laser beam (24) to a reference point (28), of the type in which the transmission of the laser beam (24) is periodically interrupted using means (30) for blocking the laser beam (24), said means being placed between the reference point (28) and a source (22) of the laser beam (24), **characterized in that** the power emitted by the source (22) of the laser beam (24) is varied between minimum and maximum values, so that the phases when the source (22) of the laser beam (24) emits at the minimum power substantially coincide with phases when the laser beam (24) is blocked by the blocking means (30), the periods when the laser beam is blocked including transition sub-periods during which the laser beam is partially blocked, the method furthermore being **characterized in that** the minimum value is at least equal to 10% of a maximum power emitted by the source (22) of the laser beam (24).

2. Control method according to Claim 1, in which the maximum value is at most equal to 90% of the maximum power emitted by the source (22) of the laser beam (24).

3. Control method according to Claim 2, in which the source (22) of the laser beam (24) is a laser diode, for example an infrared laser diode, and the power emitted is varied between the minimum value of 10% and the maximum value of 70% of a maximum power emitted by the laser diode.

4. Control method according to one of Claims 1 to 3, in which the period (P1) during which the laser beam is not blocked by the blocking means is between 500 and 1000 ms long.

5. Control method according to any one of Claims 1 to 4, in which variations in the power transmitted to the reference point (28) by the laser beam (24) and the means (30) for blocking the laser beam (24) are controlled by computer control means (34).

6. Control method according to Claim 5, in which the control means (34) are slaved to means (42) for measuring the temperature of at least one zone (Z1, Z2) the temperature of which is influenced by that of the reference point (28).

7. Control method according to any one of Claims 1 to 6, in which the laser beam (24) is focused on the reference point (28).

8. Device for controlling the power transmitted by a laser beam (24) to a reference point (28), of the type comprising a laser source (22) emitting the laser beam (24), means (30) for blocking the laser beam (24), said means being intended to periodically interrupt the laser beam (24) in blocking phases, **characterized in that** it comprises means (32) for controlling the power emitted by the source (22) of the laser beam (24) between minimum and maximum values, so that the phases when the source (22) of the laser beam (24) emits at the minimum power substantially coincide with phases when the laser beam (24) is blocked by the blocking means (30), the periods when the laser beam is blocked including transition sub-periods during which the laser beam is partially blocked, the device furthermore being **characterized in that** the minimum value is at least equal to 10% of a maximum power emitted by the source (22) of the laser beam (24).

9. Control device according to Claim 8, in which the period (P1) during which the laser beam is not blocked by the blocking means is between 500 and 1000 ms long.

10. Control device according to Claim 8 or 9, in which the laser source (22) comprises a laser diode, for example an infrared laser diode.

11. Control device according to one of Claims 8 to 10, comprising computer means (34) for controlling the means (32) for controlling the power of the laser beam emitted by the source, and the means (30) for blocking the laser beam (24).

12. Control device according to any one of Claims 8 to 11, in which the control means (34) are slaved to the temperature of at least one zone (Z1, Z2) the temperature of which is influenced by that of the reference point (28), via means (42) for measuring this temperature, which means (42) are connected to the control means (34).

13. Control device according to Claim 12, in which the means (42) for measuring the temperature comprise an infrared pyrometer (44) comprising means (46) for forming an infrared image of the zone (Z1, Z2, R).

14. Device for soldering a member (12) to a support (14) comprising first (F1) and second (F2) opposed sides, the member (12) to be soldered being intended to be borne by the first side (F1) of the support (14), the soldering device being of the type comprising a laser-beam source (22) emitting a beam (24) onto the second side (F2) of the support (14), substantially in line with the member (12) to be soldered, **characterized in that** it comprises a control device according to any one of Claims 8 to 13 for controlling the power transmitted by the laser beam (24) to a reference point (28) forming a focal point of the laser beam (24) on the second side (F2).

15. Soldering device according to Claim 14, comprising guiding means (36), comprising an optical fibre (38) and upstream means (40) for focusing the beam (24) in an upstream end of the optimal fibre (38), said guiding means (36) being intended to guide the laser beam (24) from the blocking means (30) to the reference point (28).

16. Soldering device according to Claim 15, comprising downstream means (26) for focusing the laser beam (24) emitted by a downstream end of the optical fibre (38) onto the reference point (28).

17. Method for soldering a member (12) to a support (14) comprising a metal part (PM) bordered at least partially by a part (PS) made of synthetic material, the metal part (PM) comprising first (F1) and second (F2) opposed sides, the member (12) to be soldered being intended to be borne by the first side (F1) of the metal part (PM) **characterized in that** the member (12) is soldered to the metal part (PM) of the support (14) by means of a soldering device according to any one of Claims 14 to 16, the laser beam (24) being focused on the second side (F2) of the metal part (PM).

18. Soldering method according to Claim 17, in which the member (12) is a semiconductor chip.

19. Soldering method according to Claim 17 or 18, in which the metal part (PM) of the support (14) is intended to be in electrical contact with a terminal (6) of an electrical member, especially a terminal of an alternator of an automotive vehicle, the part (PS) made of synthetic material electrically insulating the metal part (PM).

20. Soldering method according to any one of Claims 17 to 19, in which, the soldering device comprising a control device according to Claim 10 or 11, the control means (34) are slaved to the temperature of a first zone (Z1) the temperature of which is influenced by that of the reference point (28), this first zone (Z1) being defined on part of the surface of the member (12) to be soldered.

21. Soldering method according to Claim 20, in which the control means (34) are slaved to the temperature of a second zone (Z2) the temperature of which is influenced by that of the reference point (28), this second zone (Z2) being defined on part of the surface of the support (14), in particular on the metal part (PM) near the part (PS) made of synthetic material.

## Patentansprüche

1. Verfahren zur Regelung der von einem Laserstrahl (24) an einen Bezugspunkt (28) übertragenen Leistung von der Art, bei der die Übertragung des Laserstrahls (24) periodisch mit Hilfe von Verdeckungseinrichtungen (30) des Laserstrahls (24) unterbrochen wird, die zwischen dem Bezugspunkt (28) und einer Quelle (22) des Laserstrahls (24) angeordnet sind, **dadurch gekennzeichnet, dass** die Emissionsleistung der Quelle (22) des Laserstrahls (24) zwischen einem minimalen und einem maximalen Wert variiert wird, so dass die Emissionsdauern der Quelle (22) des Laserstrahls (24) mit der minimalen Leistung im Wesentlichen mit Verdeckungsdauern des Laserstrahls (24) durch die Verdeckungseinrichtungen (30) zusammenfallen, wobei die Verdeckungsperioden des Laserstrahls vorübergehende Subperioden enthalten, während denen der Laserstrahl teilweise verdeckt ist, wobei das Verfahren außerdem **dadurch gekennzeichnet ist, dass** der minimale Wert mindestens gleich 10% einer maximalen Emissionsleistung der Quelle (22) des Laserstrahls (24) ist.

2. Regelungsverfahren nach Anspruch 1, bei dem der maximale Wert höchstens gleich 90% der maximalen Emissionsleistung der Quelle (22) des Laserstrahls (24) ist.

3. Regelungsverfahren nach Anspruch 2, bei dem die Quelle (22) des Laserstrahls (24) eine Laserdiode ist, zum Beispiel von der Art mit Infrarotstrahlung, und die Emissionsleistung zwischen dem minimalen Wert von 10% und dem maximalen Wert von 70% einer maximalen Emissionsleistung der Laserdiode variiert wird.

4. Regelungsverfahren nach einem der Ansprüche 1 bis 3, bei dem die Periode (P1), während der der Laserstrahl nicht von den Verdeckungseinrichtungen verdeckt wird, eine Dauer zwischen 500 und 1000 ms hat.

5. Regelungsverfahren nach einem der Ansprüche 1 bis 4, bei dem die Variationen der durch den Laserstrahl (24) an den Bezugspunkt (28) übertragenen Leistung und die Verdeckungseinrichtungen (30) des Laserstrahls (24) mit rechnergestützten Steuereinrichtungen (34) gesteuert werden.

6. Regelungsverfahren nach Anspruch 5, bei dem die Steuereinrichtungen (34) mit Hilfe von Messeinrichtungen (42) der Temperatur mindestens einer Zone (Z1, Z2) reguliert werden, deren Temperatur von derjenigen des Bezugspunkts (28) beeinflusst wird.

7. Regelungsverfahren nach einem der Ansprüche 1 bis 6, bei dem der Laserstrahl (24) auf den Bezugspunkt (28) fokussiert ist.

8. Vorrichtung zur Regelung der von einem Laserstrahl (24) an einen Bezugspunkt (28) übertragenen Leistung, von der Art, die eine den Laserstrahl (24) emittierende Laserquelle (22) und Verdeckungseinrichtungen (30) des Laserstrahls (24) enthält, die dazu bestimmt sind, den Laserstrahl (24) periodisch während Verdeckungsdauern zu unterbrechen, **dadurch gekennzeichnet, dass** sie Einrichtungen (32) zur Verstellung der Emissionsleistung der Quelle (22) des Laserstrahls (24) zwischen einem minimalen und einem maximalen Wert enthält, so dass Emissionsdauern der Quelle (22) des Laserstrahls (24) bei der minimalen Leistung im Wesentlichen mit Verdeckungsdauern des Laserstrahls (24) durch die Verdeckungseinrichtungen (30) zusammenfallen, wobei die Verdeckungsparioden des Laserstrahls vorübergehende Subperioden enthalten, während denen der Laserstrahl teilweise verdeckt ist, wobei die Vorrichtung außerdem **dadurch gekennzeichnet ist, dass** der minimale Wert mindestens gleich 10% einer maximalen Emissionsleistung der Quelle (22) des Laserstrahls (24) ist.

9. Regelungsvorrichtung nach Anspruch 8, bei der die Periode (P1), während der der Laserstrahl nicht von den Verdeckungseinrichtungen verdeckt wird, eine Dauer zwischen 500 und 1000 ms hat.

10. Regelungsvorrichtung nach Anspruch 8 oder 9, bei der die Laserquelle (22) eine Laserdiode aufweist, zum Beispiel von der Art mit Infrarotstrahlung.

11. Regelungsvorrichtung nach einem der Ansprüche 8 bis 10, die rechnergestützte Steuereinrichtungen (34) der Verstellungseinrichtungen (32) der von der Quelle übertragenen Leistung des Laserstrahls und der Verdeckungseinrichtungen (30) des Laserstrahls (24) hat.

12. Regelungsvorrichtung nach einem der Ansprüche 8 bis 11, bei der die Steuereinrichtungen (34) auf die Temperatur mindestens einer Zone (Z1, Z2), deren Temperatur von derjenigen des Bezugspunkts (28) beeinflusst wird, mit Hilfe von Messeinrichtungen (42) dieser Temperatur reguliert werden, die mit den Steuereinrichtungen (34) verbunden sind.

13. Regelungsvorrichtung nach Anspruch 12, bei der die Messeinrichtungen (42) der Temperatur ein Infrarot-Pyrometer (44) aufweisen, das Einrichtungen (46) zum Formen eines Infrarotbilds der Zone (Z1, Z2, R) enthält.

14. Vorrichtung zum Löten eines Elements (12) auf einen Träger (14), der erste (F1) und zweite (F2) gegenüberliegende Seiten hat, wobei das zu lötende Element (12) dazu bestimmt ist, von der ersten Seite (F1) des Trägers (14) getragen zu werden, wobei die Lötvorrichtung von der Art ist, die eine Laserstrahl-Quelle (22) enthält, die einen Strahl (24) auf die zweite Seite (F2) des Trägers (14) im Wesentlichen im rechten Winkel zum zu lötenden Element (12) emittiert, **dadurch gekennzeichnet, dass** sie eine Regelungsvorrichtung nach einem der Ansprüche 8 bis 13 für die Regelung der auf dem Laserstrahl (24) an einen Bezugspunkt (28) übertragenen Leistung enthält, der einen Fokussierpunkt des Laserstrahls (24) auf der zweiten Seite (F2) bildet.

15. Lötvorrichtung nach Anspruch 14, die Führungseinrichtungen (36) enthält, die eine Lichtleitfaser (38) und vordere Fokussiereinrichtungen (40) des Strahls (24) in ein vorderes Ende der Lichtleitfaser (38) aufweisen, die dazu bestimmt sind, den Laserstrahl (24) von den Verdeckungseinrichtungen (30) bis zum Bezugspunkt (28) zu führten.

16. Lötvorrichtung nach Anspruch 15, die hintere Fokussiereinrichtungen (26) des Laserstrahls (24) auf den Bezugspunkt (28) enthält, der von einem hinteren Ende der Lichtleitfaser (38) emittiert wird.

17. Verfahren zum Löten eines Elements (12) auf einen Träger (14), der einen metallischen Teil (PM) aufweist, der zumindest teilweise von einem Teil aus Synthetikmaterial (PS) umrandet wird, wobei der metallische Teil (PM) erste (F1) und zweite (F2) gegenüberliegende Seiten aufweist, wobei das zu lötende Element (12) dazu bestimmt ist, von der ersten Seite (F1) des metallischen Teils (PM) getragen zu werden, **dadurch gekennzeichnet, dass** das Element (12) mit Hilfe einer Lötvorrichtung nach einem der Ansprüche 14 bis 16 auf den metallischen Teil (PM) des Trägers (14) gelötet wird, wobei der Laserstrahl (24) auf die zweite Seite (F2) des metallischen Teils (PM) fokussiert wird.

18. Lötverfahren nach Anspruch 17, bei dem das Element (12) ein Halbleiterplättchen ist.

19. Lötverfahren nach Anspruch 17 oder 18, bei dem der metallische Teil (PM) des Trägers (14) dazu bestimmt ist, mit einer Klemme (16) eines elektrischen Elements in Kontakt zu sein, insbesondere einer Klemme eines Wechselstromgenerators eines Kraftfahrzeugs, wobei der Teil aus Synthetikmaterial (PS) den metallischen Teil (PM) elektrisch isoliert.

20. Lötverfahren nach einem der Ansprüche 17 bis 19, bei dem, wenn die Lötvorrichtung eine Regelungsvorrichtung nach Anspruch 10 oder 11 enthält, die Steuereinrichtungen (34) auf die Temperatur einer ersten Zone (Z1) reguliert werden, deren Temperatur von derjenigen des Bezugspunkts (28) beeinflusst wird, wobei diese erste Zone (Z1) auf einem Teil der Fläche des zu lötenden Elements (12) begrenzt ist.

21. Lötverfahren nach Anspruch 20, bei dem die Steuereinrichtungen (34) auf die Temperatur einer zweiten Zone (Z2) reguliert werden, deren Temperatur von derjenigen des Bezugspunkts (28) beeinflusst wird, wobei diese zweite Zone (Z2) auf einem Teil der Fläche des Trägers (14) begrenzt ist, insbesondere auf dem metallischen Teil (PM) nahe dem Teil aus Synthetikmaterial (PS).
